# EUROPEAN PATENT SPECIFICATION

(11) **EP 1 786 044 B1**
(45) Date of publication and mention of the grant of the patent: **20.01.2016**
(21) Application number: 06123849.9
(22) Date of filing: 10.11.2006
(51) Int. Cl.: H01L 33/12, H01L 33/32

(54) **Superlattice strain relief layer for semiconductor devices**
Übergitter-Zugentlastungsschicht für Halbleitervorrichtungen
Couche super-réseau à soulagement de traction pour dispositifs à semiconducteurs

(30) Priority: 14.11.2005 US 736362 P; 17.02.2006 US 356769
(43) Date of publication of application: 16.05.2007
(60) Divisional application: 08014020.5
(73) Proprietor: Palo Alto Research Center Incorporated, Palo Alto, California 94304 (US)
(72) Inventor: Kneissl, Michael A., 10405 Berlin (DE); Yang, Zhihong, Sunnyvale, CA 94086 (US); Wong, William S., San Carlos, CA 94070 (US); Teepe, Mark R., Menlo Park, CA 94025 (US); Knollenberg, Clifford F., Mountain View, CA 94040 (US)
(74) Representative: Grünecker Patent- und Rechtsanwälte PartG mbB

(56) References cited:
- WO-A-02/097904
- US-A1- 2002 195 606
- US-A1- 2004 140 474
- US-B2- 6 875 627
- NAKAMURA S ET AL: "INGAN/GAN/A1GAN-BASED LASER DIODES WITH MODULATION-DOPED STRAINED-LAYER SUPERLATTICES" JAPANESE JOURNAL OF APPLIED PHYSICS, JAPAN SOCIETY OF APPLIED PHYSICS, TOKYO, JP, vol. 36, no. 12A, 1 December 1997 (1997-12-01), pages L1568-L1571, XP002918375 ISSN: 0021-4922
- SITAR Z: "GROWTH OF AIN/GAN LAYERED STRUCTURES BY GAS SOURCE MOLECULAR-BEAM EPITAXY" JOURNAL OF VACUUM SCIENCE AND TECHNOLOGY: PART B, AVS / AIP, MELVILLE, NEW YORK, NY, US, vol. 8, no. 2, 1 March 1990 (1990-03-01), pages 316-322, XP000237957 ISSN: 1071-1023
- CHEN C Q ET AL: "ALGAN LAYERS GROWN ON GAN USING STRAIN-RELIEF INTERLAYERS" APPLIED PHYSICS LETTERS, AIP, AMERICAN INSTITUTE OF PHYSICS, MELVILLE, NY, US, vol. 81, no. 26, 23 December 2002 (2002-12-23), pages 4961-4963, XP001144762 ISSN: 0003-6951
- CHEN C Q ET AL: "AlGaN layers grown on GaN using strain-relief interlayers", APPLIED PHYSICS LETTERS, AMERICAN INSTITUTE OF PHYSICS, US, vol. 81, no. 26, 23 December 2002 (2002-12-23), pages 4961-4963, XP012032869, ISSN: 0003-6951, DOI: 10.1063/1.1531219

## Description

### BACKGROUND OF THE INVENTION

### 1. Field of the Invention.

The present invention is related generally to the field of light emitting diode devices, and more specifically to an architecture for an improved high-Al content, low defect heterostructure quantum well surface emitting light emitting diode device.

### 2. Description of the Prior Art.

In the III-V compound semiconductor family, the nitrides have been used to fabricate visible wavelength light emitting diode active regions. They also exhibit a sufficiently high bandgap to produce devices capable of emitting light in the ultraviolet, for example wavelengths between 300 and 400 nanometers. In particular, InAlGaN systems have been developed and implemented in visible and UV spectrum light emitting diodes (LEDs), such as disclosed in U.S. Patent 6,875,627 to Bour et al. These devices are typically formed on an Al₂O₃ (sapphire) substrate, and comprise thereover a GaN:Si or AlGaN template layer, an AlGaN:Si/GaN superlattice structure for reducing optical leakage, an n-type electrode contact layer, a GaN n-type waveguide, an InGaN quantum well heterostructure active region, and a GaN p-type waveguide region. In addition, the complete device may also have deposited thereover a p-type AlGaN:Mg cladding layer and a capping layer below a p-type electrode.

While significant improvements have been made in device reliability, optical power output, and mode stability, the performance of the nitride-based light emitting diode emitting in the ultraviolet (UV) is still far inferior to that of blue or green light emitting diode. It is particularly true that for the UV light emitting diodes, the nature of the substrate and template layer have a critical impact on the overall device performance. For example, electrical resistance between the structural layers of the device significantly effects optical output. While Al₂O₃ (sapphire) as a substrate has numerous advantages, the AlGaN template layer formed over the typical Al₂O₃ substrate posses high series resistance due to limited doping capabilities. Furthermore, the crystallographic structure of the device layers plays a key role in the device's operational characteristics, and the AlGaN template layer provides a relatively poor crystalline template.

The dislocation densities in AlGaN or AIN template layers on sapphire are typically in the mid 10⁹ to high 10¹⁰ cm⁻² range. As a consequence, the external quantum efficiencies of deep UV light emitting diodes in the 250 nm to 350 nm range are still below 2% even for the very best devices (external quantum efficiencies near 50% have been demonstrated for blue GaN-based LED structures). The high dislocation densities in AlGaN or AIN template layers on sapphire also pose significant problems for the light emitting diode device lifetimes.

GaN epitaxial layers on sapphire substrates have proven to be a better template for InGaAlN film growth, providing excellent optoelectronic quality for visible light emitting diode devices and reasonable dislocation densities. The dislocation densities in GaN template layers on sapphire are typically in the low 10⁹ to mid 10⁷ cm⁻² ranges. Accordingly, sapphire with a GaN template layer is the preferred foundation for visible GaN-based light emitting diodes.

The output wavelength of the light emitting diode is inversely related to the Al content in the multiple quantum well heterostructure (MQWH) active region of the device. Thus, in order to obtain shorter wavelength devices, such as those emitting in the UV, the Al content of the HQWH region must be increased over that found in devices emitting in the visible spectrum. However, increasing the Al content presents a number of structural and device performance problems.

Furthermore, efforts to improve the quality of the LED structure in the ultraviolet range on GaN/sapphire template have presented significant challenges due to the large lattice mismatch between the epitaxial layers formed over the GaN crystallographic template which is known to lead to strain-induced cracking. This lattice mismatch is exacerbated when the Al content of layers formed above the GaN/sapphire system increases. Yet, as previously mentioned, an increased Al content (e.g., up to ∼50% in the MQWH active region of a 280nm light emitting diode, and 60% to 70% in the surrounding AlGaN current and optical confinement layers) is required to obtain devices which emit in the UV. A UV InAlGaN heterostructure grown on GaN/sapphire is under tensile stress, which causes cracking of the AlGaN epitaxial layers when the critical layer thickness is exceeded. The critical thickness for an AlGaN film with a 50% aluminum mole fraction is about 20-50nm, which is much too thin for realizing a usable device structure in the deep UV. Efforts to provide strain relief to accommodate the lattice mismatch have heretofore proven unsuccessful or impractical.

Various groups have published approaches to dealing with these shortcomings. For example, Han et al., Appl. Phys. Lett, Vol 78, 67 (2001), discuss the use of a single AIN interlayer formed at low temperatures to avoid strain development. This low-temperature AIN interlayer approach has proven unsuccessful in the case of heterostructure growth with high Al mole fractions. Nakamura et al., J. J. Appl. Phys., vol. 36, 1568 (1997) has suggested short period GaN/AlGaN superlattice layers as a way of extending the critical layer thickness of AlGaN films grown pseudomorphically on GaN/sapphire. But the average Al mole fraction in these AlGaN/GaN systems is at such a low level (∼10% or less) that it is not compatible with deep UV light emitting diodes. Finally, Chen et al., Appl. Phys. Lett., vol. 81, 4961 (2002) suggests an AlGaN/AlN layer as a dislocation filter for an AlGaN film on a AlGaN/sapphire template. But again, the AlGaN/sapphire template presents the aforementioned series resistance problem. There is a need for a deep UV light emitting diode apparatus with improved operation characteristics, and therefore, there is a need for a method and structure facilitating a high Al content MQWH active region which is free from cracking and related damage.

US 6,875,627 describes structure and method for index-guided buried heterostructure AlGalnN laser diodes. An index-guided buried heterostructure AlGalnN laser diode provides improved mode stability and low threshold current when compared to conventional ridge waveguide structures. A short period superlattice is used to allow adequate cladding layer thickness for confinement without cracking. The intensity of the light lost due to leakage is reduced by about 2 orders of magnitude with an accompanying improvement in the far-field radiation pattern when compared to conventional structures.

NAKAMURA S ET AL: "INGAN/GAN/A1GAN-BASED LASER DIODES WITH MODULATION-DOPED STRAINED-LAYER SUPERLATTICES" JAPANESE JOURNAL OF APPLIED PHYSICS, JAPAN SOCIETY OF APPLIED PHYSICS, TOKYO, JP, vol. 36, no. 12A, 1 December 1997, pages L1568-L1571, ISSN:0021-4922.

US 2002/0195606 A1 describes group III nitride LED with undoped cladding layer and multiple quantum well.

SITAR Z: "GROWTH OF AIN/GAN LAYERED STRUCTURES BY GAS SOURCE MOLECULAR-BEAM EPITAXY" JOURNAL OF VACUUM SCIENCE AND TECHNOLOGY: PART B, AVS / AIP, MELVILLE, NEW YORK, NY, US, vol. 8, no. 2, 1 March 1990, pages 316-322, ISSN: 1071-1023.

### SUMMARY OF THE INVENTION:

It is the object of the present invention to improve light emitting diode devices and manufacture thereof. This object is achieved by providing a method of manufacturing a semiconductor light-emitting diode according to claim 1.

Embodiments of the invention are set forth in the dependent claims.

### BRIEF DESCRIPTION OF THE DRAWINGS

These and other aspects, features, and advantages of the present invention will become apparent from the following detailed description and the appended drawings in which like reference numerals denote like elements between the various drawings, but which are not drawn to scale.
Fig. 1 is a cross-sectional view of a multiple quantum-well heterostructure light emitting diode, including a GaN/AIN superlattice, according to an embodiment of the present invention.
Figs. 2A-2F are illustrations of the steps involved in a laser lift-off (LLO) and etch process to produce a surface-emitting light emitting diode.
Fig. 3 is a detailed view of a GaN/AIN superlattice structure according to an embodiment of the present invention.
Fig. 4 is a scanning electron microscope (SEM) view of a partial multiple quantum-well heterostructure light emitting diode structure grown on GaN/sapphire template, including a GaN/AlN superlattice, according to an embodiment of the present invention.
Fig. 5 is a voltage versus current graph, showing acceptable device performance, for a deep UV light emitting diode grown on a GaN/sapphire template with a GaN/AIN superlattice strain relief structure according to the present invention.
Fig. 6 is a graph of the Emission spectra (wavelength versus light output), for a deep UV light emitting diode grown on a GaN/sapphire template with a GaN/AIN superlattice strain relief structure according to the present invention.
Figs. 7A-7D are SEM micrographs of a deep UV emitting diode grown on a GaN/sapphire template with the number of layers comprising the superlattice strain relief structure at zero, 20, 40, 60, and 80 layer pairs of GaN/AlN, respectively.
Figs. 8A-8F are illustrations of the steps involved in a laser lift-off (LLO) and etch process to produce a surface-emitting light emitting diode according to an embodiment of the present invention.

### DETAILED DESCRIPTION OF THE INVENTION

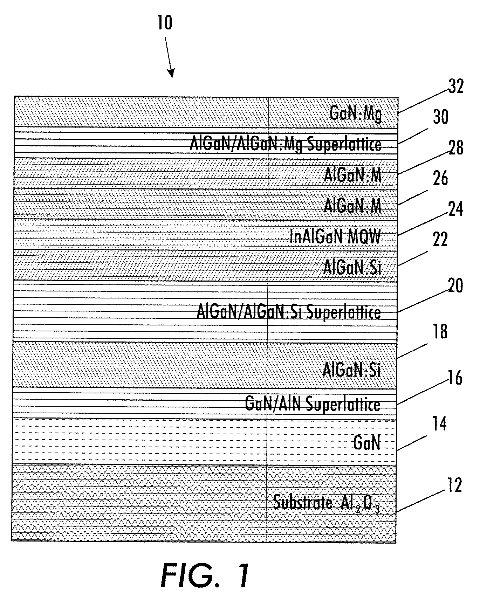

With reference now to Fig. 1, there is shown therein an index guided, buried heterostructure AlGalnN light emitting diode structure 10 in accordance with the present invention. Diode structure 10 comprises an Al₂O₃ (sapphire) substrate 12 on which is formed a 2-10 micron thick epitaxial GaN template layer 14. GaN template layer 14 can be Si-doped or undoped and is typically grown at approximately 1100 degree C and a reactor pressure of approximately 200 Torr. Formed thereon is a GaN/AlN superlattice layer 16, described further below. Formed next is AlGaN:Si buffer layer 18, and formed thereon is AlGaN/AlGaN:Si superlattice n-strain layer 20 which allows for increased cladding thickness and hence reduced optical leakage of subsequent layers. Formed next is AlGaN:Si n-cladding (index guiding) layer 22. InAlGaN multiple quantum well active layer 24 is formed on layer 22. Formed thereon is AlGaN:Mg p-cladding (index guiding) layer 26, then AlGaN:Mg buffer layer 28. AlGaN/AlGaN:Mg p-strain layer 30 is next deposited, then finally a GaN:Mg capping layer is formed over the structure. The aforementioned layers may be formed, for example, as described in the aforementioned incorporated U.S. Patent 6,875,627 to Bour et al. It will be appreciated that a complete device will also include electrodes, not shown, as well as other similar or alternative devices formed in the manner of an array in appropriate embodiments.

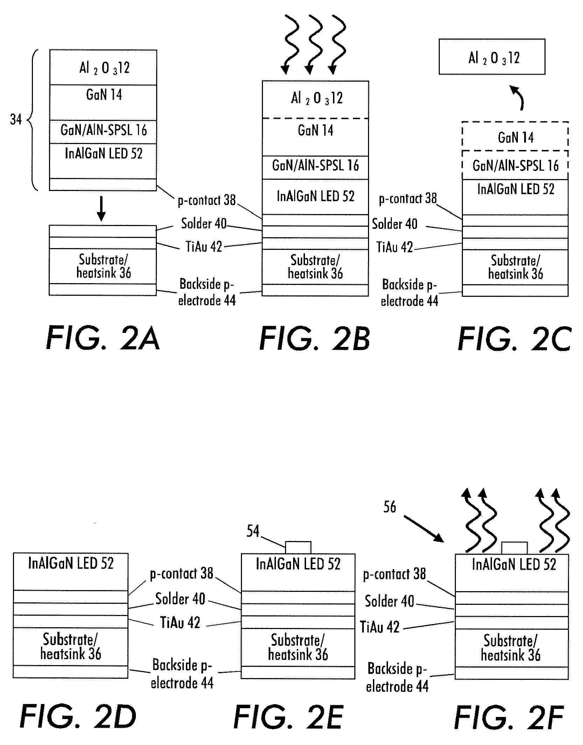

The structure produced is a light emitting diode designed, for example, to emit UV light through the substrate. Since the GaN template layer is absorptive at UV wavelengths, optimal device performance may be obtained by removal of substrate 12 and GaN template layer 14. This may preferably be accomplished by the method, referred to herein as a laser lift-off (LLO) process, described in U.S. Patent 6,757,314. One LLO method bonds a combination substrate/heat sink to a surface opposite the Al₂O₃ substrate. An excimer laser is typically employed to decouple the Al₂O₃ substrate from the GaN layer, allowing removal of the substrate, the GaN layer is then removed by a chemical process (e.g., dry etch). Some or all of GaN/AIN superlattice layer 16 is also removed by the chemical process at this point. A variation on this method first bonds an intermediate wafer to a surface opposite the Al₂O₃ substrate. The Al₂O₃ substrate and GaN layer are removed, and the device is then bonded to one of a variety of UV transparent substrates at the surface previously occupied by the GaN layer and Al₂O₃ substrate. An example of such a process for removing the substrate and GaN template layer is illustrated in Figs. 2A-2F, which merely schematically illustrate the light emitting diode according to the present invention (i.e., not all layers thereof are shown in these figures.)

With reference first to Fig. 2A, a light emitting diode 34 (or an array of such devices) of a type described above is indirectly secured (e.g., flip-chip, thermally, or acoustically bonded) to a substrate 36 with high thermal conductivity (such as copper, diamond, bulk AIN, or silicon) to serve as a heat sink. Ideally, the first metal contact 38 (p-contact) of the light emitting diode would be bonded to a solder 40/AuTi 42 layer pair on substrate/heatsink 36 (which may or may not be patterned), with the solder reflowing or deforming to form a permanent electrical, thermal, and mechanical contact/bond between the light emitting diode 34 and substrate/heat sink 36. In some cases the substrate/heatsink may be electrically conductive as well as thermally conductive, providing an electrical contact to the first contact 38 (p-contact) of the light emitting diode structure 34. In such cases an additional contact layer 44 may be placed on the backside of the substrate/heatsink 36 to improve electrical contacting.

Reference is now made to Fig. 2B. With the light emitting diode structure 34 affixed to substrate/heatsink 36, an excimer laser is scanned over the Al₂O₃ substrate 12. Due to the bandgap between GaN and its surrounding materials, there is high absorption of the light at the interface between the Al₂O₃ substrate 12 and the GaN layer 14. This effectively results in decomposition of the GaN material at the sapphire/GaN interface, weakening or breaking the bond between the two layers. A second step to melt the transformed interface (typically at temperatures greater than the melting point of Ga (Tm ~ 30 C°) will further weaken the interface bond. With the bond sufficiently weakened, the Al₂O₃ substrate 12 may simply be mechanically removed from the light emitting diode structure 34, as shown in Fig. 2C.

The residual GaN layer 14 (typically several microns thick) and some or all of the GaN/AIN superlattice 16 are then removed using a dry etch (e.g., CAIBE) or possibly wet etching method. The structure is then substantially as shown in Fig. 2D. A second electrical contact 54 (n-contact) is then patterned directly on the exposed InAlGaN light emitting diode structure 52. This may be achieved in a variety of ways including (but not limited to) standard photolithography or a shadow mask processes. The structure is then as shown in Fig. 2E. The final light emitting diode structure 56 permits light extraction through an upper surface, and electrical contact directly to the light emitting diode active region via the contacts 44, 54 placed in direct contact on opposite sides of the active region.

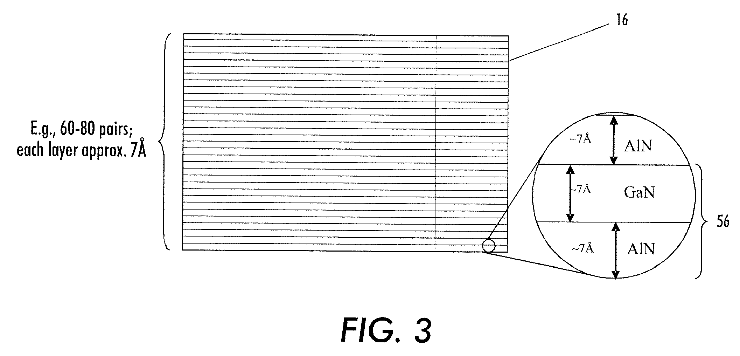

With reference now to Fig. 3, there is shown therein an exemplary embodiment of GaN/AlN superlattice 16, with layers grown in matched pairs 56 with GaN grown on top of AIN (that is, AIN is grown first upon GaN layer 14, then a layer of GaN, then another layer of AIN, and so forth with GaN as the final layer in the superlattice 16, and upon which AlGaN layer 18 is grown). Each of the superlattice pairs consists of an approximately 7A wide GaN layer and an approximately 7Å wide AIN layer. The AIN and GaN layers are grown at approximately 1100 degree C° and approximately 200 Torr reactor pressure. The growth rate for the AIN and GaN layer was approximately -0.5 Å /sec. Superlattice layer 16 is nominally undoped, but could be doped (e.g., Si) by methods known in the art.

It will be appreciated that a critical role of GaN/AIN superlattice 16 is to permit the incorporation of higher amounts of Al in subsequently deposited layers than previously possible, due to the reduced defects in layers deposited over superlattice 16. However, forming each component layer of the superlattice 16 requires setting of processing equipment controls and the introduction of constituent components, thus taking time and consuming processing resources. Therefore, there is a balance to be struck between growing a minimal number of layer pairs to simplify processing and a sufficient number of pairs to allow for a crack-free high Al content heterostructure.

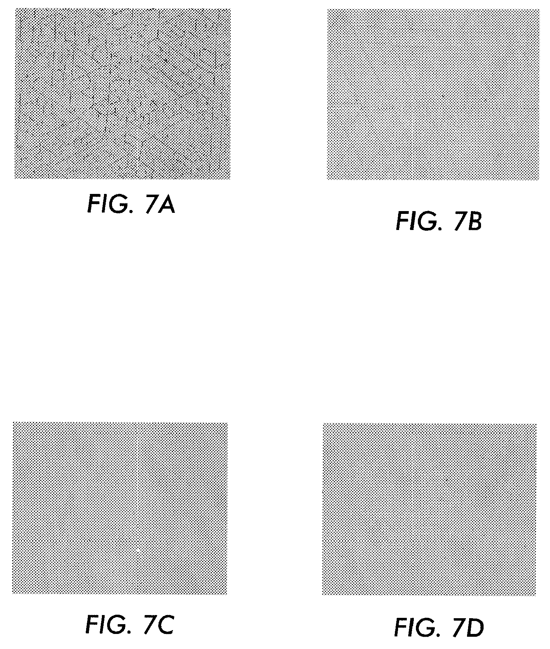

In quantifying this balance, the number of GaN/AIN superlattice pairs was varied between 20 and 80. Upon completion of a UV light emitting diode structure of the type described with regard to Fig. 1, with an Al mole fraction of the AlGaN layers at 25-40%, substrate 12, GaN template layer 14, and superlattice 16 were removed by processes described above and in aforementioned U.S. Patent 6,757,314. The remaining completed devices were examined for structural integrity, and surface condition of AIGaN layer 18. (It is critical that AlGaN layer 18 be crack free so as to provide a suitable foundation for the subsequent layers, and further that the multiple quantum well heterostructure active layer be crack free for device performance.) Furthermore, optical performance of each device was measured. A 20 pair superlattice 16 produced a device which exhibited significant surface irregularity and cracks in the layer 18. Structural cracking decreased in structures with 40 superlattice pairs, but still showed some surface irregularity and cracks. Optimal results (freedom from structural cracks, surface smoothness, light emitting diode performance, minimal number of layer pairs) were obtained for a structure which included a superlattice 16 consisting of 80 GaN/AlN pairs. At 80 superlattice pairs layer 18 showed virtually no detectable damage or cracks. Table 1 summarizes these results. Figs. 7A-7D are SEM micrographs showing the visible results for this experiment.

**Table 1**

| Number Of AlN/GaN Superlattice Pairs (All 7 Å /7 Å) | Surface After Led Growth On GaN/Sapphire | Light Emitting Diode Wavelength | Light Emitting Diode Relative Intensity | SEM Photograph |
|---|---|---|---|---|
| 0 | Extremely heavily cracked | Inoperable | inoperable | Fig. 7A |
| 20 | Heavily cracked | 328.8nm | 1 | Fiq. 7B |
| 40 | A few cracks | 329.8nm | 1.45 | Fig. 7C |
| 80 | Good, No cracks | 328.3nm | 3.6 | Fig. 7D |

Appropriate thicknesses of the superlattice layers were also explored by varying each layer thickness between 7 and 14 Å for each of the GaN the AIN layers. The devices were prepared as previously described, and the surface of layer 18 examined. The cracking seemed not to be affected by a change of superlattice layer thickness, although the x-ray diffraction examination (XRD) at full-width half-maximum (FWHM) was the narrowest for the case in which each of the GaN and AIN layers were each 7Å in thickness. Table 2 summarize these results.

**Table 2**

| AIN/GaN Superlattice Thickness (All 80 Pairs) | (0006) XRD FWHM Of AlGaN Epitaxial Layer On GaN |
|---|---|
| 7/7 Å | 366"-785" |
| 7/14 Å | 418"-680" |
| 14/7 Å | 576" |

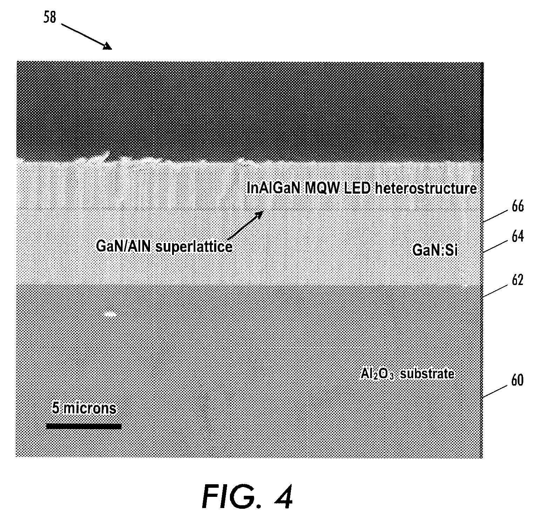

Fig. 4 shows a cross-sectional SEM image of a UV light emitting diode heterostructure 58, capable of emission at 325nm. Layers not specifically shown in Fig. 4 are either too thin to be seen in the SEM image or have low contrast (because of layer doping) as compared with nearby layers. (E.g. The contact layer on top of the structure is only 20nm and can not be seen in the SEM picture). Structure 58 includes an Al2O3 substrate 60, a GaN:Si template layer 62 formed on and over substrate 60, an 80 layer-pair GaN/AIN superlattice 64 formed on and over GaN:Si layer 62, and an InAlGaN multiple quantum well heterostructure layer 66 formed on and over superlattice 64. Each layer in superlattice 64 is approximately 7Å thick. The Al content in layer 66 was in the range of 35-40%. As can be seen, in cross section no cracks are visible in layer 66, a feature attributable to the provision of superlattice 64 thereunder.

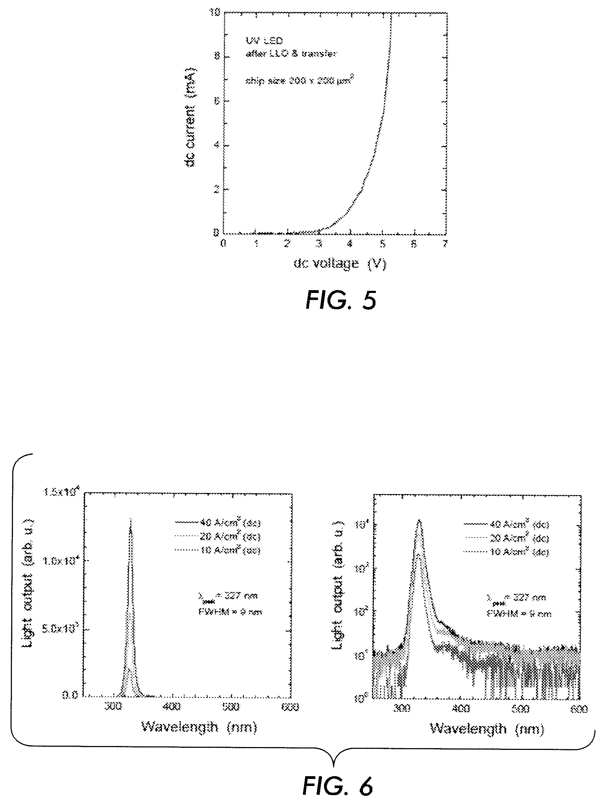

With reference to Fig. 5 device voltage versus current performance is shown for a deep UV light emitting diode grown on a GaN/sapphire template with a GaN/AIN superlattice strain relief structure according to the present invention (performance measured after removal of the substrate, etching of the GaN and GaN/AlN superlattice and transfer onto a quartz wafer) with peak emission around 327nm. Likewise, with reference to Fig. 6, shown therein is the emission spectra of the UV light emitting diode whose voltage-current data is shown in Fig. 5. The characterization data shows that after LLO and transfer of the device to a quartz substrate, the Deep UV LED still has good device performance, i.e. good IV performance, and narrow and clean emission spectra which indicate overall good material and device quality.

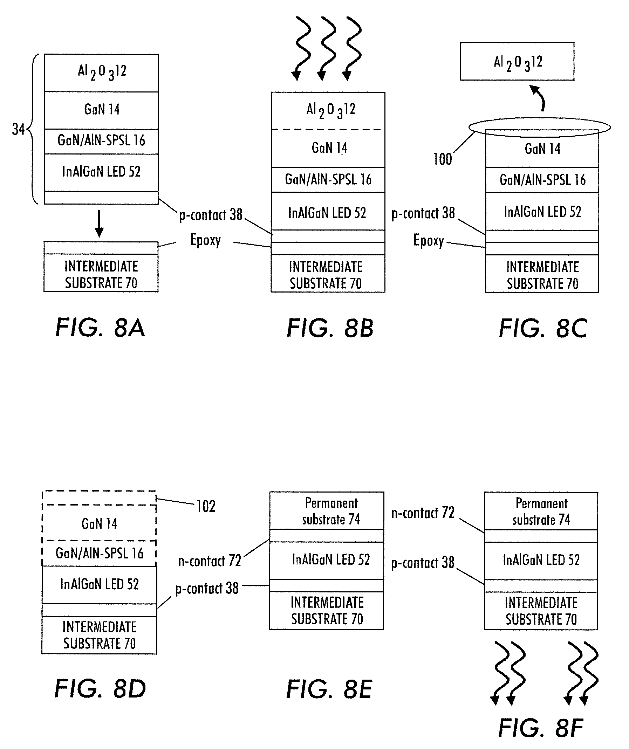

According to an embodiment of a method according to the current invention for the production of a surface emitting LED shown in Figs. 8A through 8F, a UV LED structure is transferred in fabrication from a sapphire substrate to UV transparent material/substrate via an intermediate host substrate. The intermediate host substrate may be quartz, a flex substrate that facilitates integration of the LED device into larger systems, etc.

Initially, an intermediate (possibly UV transparent) substrate 70 is bonded to a surface of the UV LED structure opposite the sapphire substrate using an adhesive/epoxy, as shown in Fig. 8A. ALLO procedure is performed (as described previously), removing the sapphire substrate from the GaN layer, as shown in Figs. 8B and 8C. Etching then removes GaN layer 14 (optionally a sacrificial planarizaing layer 102 may be applied prior to etching), leaving the LED active region 52 (as well as additional layers) on the intermediate substrate, as shown in Fig. 8D. An n-contact layer 72 is then formed over the LED active region 52. Permanent substrate 74 is then bonded using a UV transparent epoxy (e.g., Epotek 301-2FL) to n-contact layer 72 (or alternatively, the substrate may form the n-contact, in which case substrate 74 is bonded directly to LED active region 52), as shown in Fig. 8E. In some instances a protective layer(s) may be applied to the lateral sides of the LED to insure the UV transparent epoxy does not bond with the intermediate substrate.

Two options are now possible, each illustrated in Fig. 8F. In the method according to the current invention, the LED structure is released from the intermediate substrate 58 by emersion in a solvent (e.g., acetone) that dissolves the epoxy bonding the intermediate substrate 58 to the structure. Intermediate substrate 58 is then removed, leaving a device in which electrical contact is made from the top while light is extracted from the bottom of the device. In an alternative method, intermediate substrate is UV transparent, and need not be removed. This also produces a device in which electrical contact is made from the top while the light is extracted from the bottom.

According to the present invention, a GaN/AIN strain relief layer formed over a GaN/sapphire template facilitates the formation of a substantially defect-free relatively high Al-content layer thereover. While particularly useful in optical systems, the present invention may also find applicability in non-optical systems. For example, copending U.S. Patent application serial number 10/952,202, which is incorporated by reference herein, discloses high electron mobility transistors (HEMTs) in which a relatively high Al-content AlGaN buffer layer is formed below an undoped GaN layer. The provision of a GaN/AlN strain relief layer in such a system may provide an improved quality AlGaN layer and hence improved quality GaN layer, ultimately providing improved device performance. Accordingly, another method provides a GaN/AlN strain relief layer for the growth of low defect, relatively high Al-content films over a GaN/sapphire template useful for non-optical applications.

In the present invention, a GaN/AIN superlattice is formed over a GaN/sapphire template to serve in part as a strain relief layer for growth of deep UV light emitting diodes. Furthermore, it has been demonstrated that a GaN/AlN superlattice can be successfully used to mitigate the strain between a GaN/sapphire template and a high Al mole fraction deep UV light emitting diode heterostructure. Deep UV light emitting diodes have successfully been grown using this technique and working light emitting diodes have been demonstrated, including devices having a substrate removed by excimer laser lift-off.

## Claims

1. A method of manufacturing a semiconductor light emitting diode (10) comprising the steps of:
forming over and in contact with a substrate (12) a GaN template layer (14);
forming over and in contact with said GaN template layer (14) a superlattice structure (16), said superlattice structure (16) comprising a plurality of layer pairs (56), a first layer of said layer pairs being AIN and a second layer of said layer pairs being GaN; and
forming over said superlattice structure (16) a multiple quantum well heterostructure (24), of a composition including at least 25% aluminium, wherein
the method further comprising the steps of:
forming a contact layer (38) over said multiple quantum well heterostructure (24); securing a transfer substrate (70) to said contact layer (38);
removing said substrate (12) and said GaN template layer (14);
securing said semiconductor light emitting diode to a planar heat sink body (36) at a surface opposite said transfer substrate (70); and
removing said transfer substrate (70) from said semiconductor light emitting diode;
whereby said semiconductor light emitting diode may emit light generally perpendicularly to the plane of the heat sink body (36).

2. The method according to claim 1 further comprising the step of removing said superlattice structure (16).

3. The method according to claim 1,
wherein each layer of each said layer pair (56) is about 7Å (0.7 nm) thick.

4. The method according to any of claims 1 to 3,
wherein said light emitting diode is capable of emitting light at a wavelength of approximately 325 nm.

## Patentansprüche

1. Verfahren zum Herstellen einer Halbleiter-Leuchtdiode (10), das die folgenden Schritte umfasst:
Ausbilden einer Template-Schicht (14) aus GaN über einem Substrat (12) und in Kontakt damit;
Ausbilden einer Supergitter-Struktur (16) über und der Template-Schicht (14) aus GaN und in Kontakt damit, wobei die Supergitter-Struktur (16) eine Vielzahl von Schicht-Paaren (56) umfasst und eine erste Schicht der Schicht-Paare aus AIN besteht und eine zweite Schicht der Schicht-Paare aus GaN besteht; und
Ausbilden einer Multiple-Quantum-Well-Heterostruktur (24) aus einer Zusammensetzung, die wenigstens 25 % Aluminium enthält, über der Supergitter-Struktur (16), wobei das Verfahren des Weiteren die folgenden Schritte umfasst:
Ausbilden einer Kontaktschicht (38) über der Multiple-Quantum-Well-Heterostruktur (24):
Anbringen eines Übertragungs-Substrats (70) an der Kontaktschicht (38);
Entfernen des Substrats (12) und der Template-Schicht (14) aus GaN;
Anbringen der Halbleiter-Leuchtdiode an einem planen Kühlkörper (36) an einer dem Übertragungs-Substrat (70) gegenüberliegenden Fläche; und
Entfernen des Übertragungs-Substrats (70) von der Halbleiter-Leuchtdiode,
wobei die Halbleiter-Leuchtdiode Licht im Allgemeinen senkrecht zu der Ebene des Kühlkörpers (36) emittieren kann.

2. Verfahren nach Anspruch 1, das des Weiteren den Schritt des Entfernens der Supergitter-Struktur (16) umfasst.

3. Verfahren nach Anspruch 1,
wobei jede Schicht des Schicht-Paars (56) ungefähr 7 Å (0,7 nm) dick ist.

4. Verfahren nach einem der Ansprüche 1 bis 3,
wobei die Leuchtdiode in der Lage ist, Licht mit einer Wellenlänge von ungefähr 325 nm zu emittieren.

## Revendications

1. Procédé de fabrication d'une diode (10) électroluminescente à semi-conducteurs comprenant les étapes de :
formation par-dessus et en contact avec un substrat (12) d'une couche (14) de gabarit de GaN ;
formation par-dessus et en contact avec ladite couche (14) de gabarit de GaN d'une structure (16) de super-réseau, ladite structure (16) de super-réseau comprenant une pluralité de paires (56) de couches, une première couche desdites paires de couches étant AlN et une deuxième couche desdites paires de couches étant GaN ; et
formation par-dessus ladite structure (16) de super-réseau d'une hétérostructure (24) à puits quantiques multiples, d'une composition incluant au moins 25% d'aluminium, dans lequel
le procédé comprenant en outre les étapes de :
formation d'une couche (38) de contact par-dessus ladite hétérostructure (24) à puits quantiques multiples ;
fixation d'un substrat (70) de transfert à ladite couche (38) de contact ;
élimination dudit substrat (12) et de ladite couche (14) de gabarit de GaN ;
fixation de ladite diode électroluminescente à semi-conducteurs sur un corps planaire (36) de dissipateur de chaleur au niveau d'une surface opposée audit substrat (70) de transfert ; et élimination dudit substrat (70) de transfert de ladite diode électroluminescente à semiconducteurs ;
d'où il résulte que ladite diode électroluminescente à semi-conducteurs peut émettre une lumière de façon générale perpendiculairement au plan du corps (36) de dissipateur de chaleur.

2. Procédé selon la revendication 1 comprenant en outre l'étape d'élimination de ladite structure (16) de super-réseau.

3. Procédé selon la revendication 1, dans lequel chaque couche de chaque dite paire (56) de couches a une épaisseur d'environ 7 Å (0,7 nm).

4. Procédé selon l'une quelconque des revendications 1 à 3, dans lequel ladite diode électroluminescente est apte à émettre une lumière à une longueur d'onde d'approximativement 325 nm.
